# EUROPEAN PATENT APPLICATION

(11) **EP 2 770 806 A1**
(43) Date of publication of application: **27.08.2014**
(21) Application number: 12841704.5
(22) Date of filing: 11.10.2012
(51) Int. Cl.: H05K 3/00, B23H 7/38, B26F 1/28, B26F 1/31, H01L 23/12

(54) **METHOD FOR FORMING THROUGH HOLES IN INSULATING SUBSTRATE AND METHOD FOR MANUFACTURING INSULATING SUBSTRATE FOR INTERPOSER**

(30) Priority: 20.10.2011 JP 2011231101
(71) Applicant: Asahi Glass Company, Limited, Tokyo 100-8405 (JP)
(72) Inventor: TAKAHASHI, Shintaro, Tokyo 100-8405 (JP); MORI, Satoshi, Tokyo 100-8405 (JP)
(74) Representative: Müller-Boré & Partner Patentanwälte PartG mbB
(86) International application number: PCT/JP2012/076360
(87) International publication number: WO 2013/058169

(57) **Abstract**

A method including (a) preparing an insulating substrate, and (b) forming n (n is an integer equal to or greater than 9) through holes on the insulating substrate in a through hole density in a range of 1000 pieces/cm² to 20000 pieces/cm² at a pitch P (µm) in a range of 20 µm to 300 µm, wherein (b) is performed on a front surface of the insulating substrate and includes (b1) forming a first through hole at a first target position, (b2) forming a second through hole at a second target position, wherein a distance between the first target position and the second target position is greater than the pitch P (µm) ..., and (bn) forming an n-th final through hole at an n-th target position, wherein a distance between the (n-1) target position and the n-th target position is greater than the pitch P (µm).

## Description

### TECHNICAL FIELD

The present invention relates to a method of forming a through hole in an insulating layer used at a time of manufacturing an interposer or the like.

### BACKGROUND ART

A fluorescent lamp may be put to various use, including an illumination for home use, a back light of a display unit, light irradiation at various stages of production, and the like.

Conventionally, disclosed is a method of manufacturing an insulating substrate for an interposer by forming a plurality of through holes (vias) by irradiating an insulating substrate with a laser beam (for example, patent document 1).

Further, there is recently disclosed a technique of opening a through hole in an insulating substrate by using an electrical discharge machining technique (a laser-induced electrical discharge machining technique) (for example, patent document 2). With this method, after a desired position of an insulating layer is heated by using a laser beam, this heated position becomes molten by induced discharge and a molten material is removed. With this method, it is disclosed that the through hole can be more rapidly formed in the insulating substrate than a method of using only a laser beam.

### PRIOR ART DOCUMENTS

### PATENT DOCUMENTS

Patent Document 1: International Publication No. WO 2010/087483
Patent Document 2: International Publication No. WO 2011/038788

### DISCLOSURE OF THE INVENTION

### PROBLEM TO BE SOLVED BY THE INVENTION

As described above, the laser-induced electrical discharge machining technique enables the through hole to be rapidly formed in the insulating substrate.

However, a crack may occur in the insulating substrate by accumulated thermal stress when a first through hole is formed and thereafter a second through hole adjacent to the first through hole is formed by this method.

The present invention is conceived in view of the above problem, and one object of the present invention is to provide a method of hardly causing a crack at a time of forming a through hole in an insulating substrate using a laser-induced electrical discharge machining technique.

### MEANS OF SOLVING THE PROBLEM

According to an aspect of the present invention, there is provided a method of forming a through hole in an insulating substrate using a laser-induced electrical discharge machining technique including (a) preparing the insulating substrate; and (b) forming n (n is an integer equal to or greater than 9) through holes on the insulating substrate in a through hole density in a range of 1000 pieces/cm² to 20000 pieces/cm² at a pitch P (µm) in a range of 20 µm to 300 µm, wherein (b) includes: (b1) forming a first through hole at a first target position on a front surface of the insulating substrate, (b2) forming a second through hole at a second target position on the front surface of the insulating substrate, wherein a distance between the first target position and the second target position is greater than the pitch P (µm), and (bn) forming an n-th final through hole at an n-th target position on the front surface of the insulating substrate, wherein a distance between the (n-1) target position and the n-th target position is greater than the pitch P (µm).

According to another aspect of the present invention, after a j-th (j is an integer between 1 to n-1) through hole is formed at a j-th target position on the surface of the insulating substrate, a (j+1)-th target position where (j+1)-th through hole is formed may be selected from a plurality of target positions, which exist at 4 target positions distanced by a doubled pitch 2P from the j-th target position in upward, downward, rightward, and leftward directions and exist on sides of a square having its vertexes at the target positions distanced by the doubled pitch 2P from the j-th target position in the upward, downward, rightward, and leftward directions.

Further, according to another aspect of the present invention, there is provided a method of manufacturing an insulating substrate for an interposer having a plurality of through holes using a laser-induced electrical discharge machining technique including (a) preparing the insulating substrate; and (b) forming n (n is an integer equal to or greater than 9) through holes on the insulating substrate in a through hole density in a range of 1000 pieces/cm² to 20000 pieces/cm² at a pitch P (µm) in a range of 20 µm to 300 µm, wherein (b) includes (b1) forming a first through hole at a first target position on a front surface of the insulating substrate, (b2) forming a second through hole at a second target position on the front surface of the insulating substrate, wherein a distance between the first target position and the second target position is greater than the pitch P (µm), and (bn) forming an n-th final through hole at an n-th target position on the front surface of the insulating substrate, wherein a distance between the (n-1) target position and the n-th target position is greater than the pitch P (µm).

Other objects, features and advantages of the present invention will become more apparent from the following detailed description when read in conjunction with the accompanying drawings.

### EFFECTS OF THE INVENTION

The present invention may provide a method of hardly causing a crack at a time of forming a through hole in an insulating substrate using a laser-induced electrical discharge machining technique.

### BRIEF DESCRIPTION OF THE DRAWINGS

FIG. 1 illustrates an exemplary structure of a laser-induced electrical discharge machine used for a laser-induced electrical discharge machining technique;
FIG. 2 schematically illustrates states of forming a plurality of through holes 185A and 185B in an insulating substrate 180 using the laser-induced electrical discharge machine 100 illustrated in FIG. 1;
FIG. 3 is a plan view of a part of the insulating substrate 180;
FIG. 4 is a plan view of a part of the insulating substrate 180;
FIG. 5 is a plan view of a part of the insulating substrate 180; and
FIG. 6 is a flow chart schematically illustrating a method of manufacturing an insulating substrate for an interposer of an embodiment of the present invention.

### MODE OF CARRYING OUT THE INVENTION

A detailed description will hereinafter be given of the present invention with reference to the drawings.

### (Laser-induced electrical discharge machining technique)

At first, a laser-induced electrical discharge machining technique used in the present invention is briefly described.

In the present invention, the "laser-induced electrical discharge machining technique" is an all-inclusive term of techniques of forming a through hole in an object to be processed by combining irradiation of laser beam onto the object to be processed with a discharge phenomenon between electrodes.

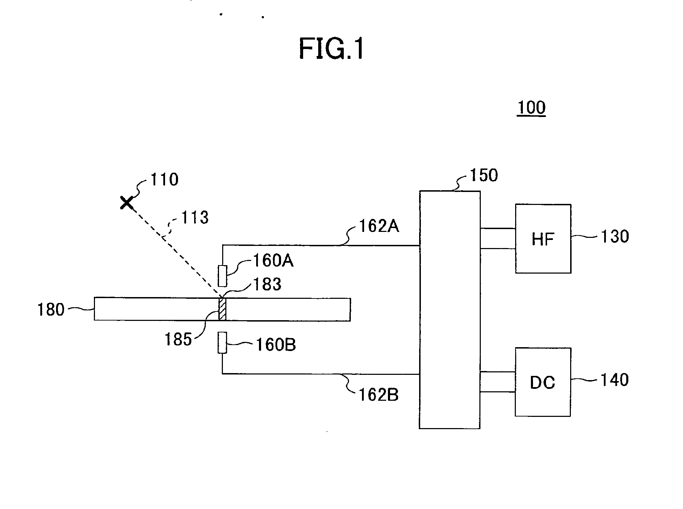

FIG. 1 schematically illustrates an exemplary structure of a laser-induced electrical discharge machine used for a laser-induced electrical discharge machining technique.

As illustrated in FIG. 1, the laser-induced electrical discharge machine 100 includes a laser beam source 110, a high-frequency high-voltage power source (HF) 130, a direct current (dc) high-voltage power source (DC) 140, a switching unit 150, and a pair of electrodes 160A and 160B.

The laser beam source 110 may be a carbon dioxide laser device having, for example, an output of 1 W to 100 W and may form a focus spot in a range of 10 µm to 50 µm. The laser beam source 110 is not limited to the above.

The electrodes 160A and 160B are electrically connected with the conductors 162A and 162B, respectively. The conductors 162A and 162B are connected with the high-frequency high-voltage power source (HF) 130 and the DC high-voltage power source (DC) 140 through the switching unit 150.

The switching unit 150 has a function of switching the connection destination of the conductors 162A and 162B between the high-frequency high-voltage power source (HF) 130 and the DC high-voltage power source (DC) 140.

When the through hole is formed by using the laser-induced electrical discharge machine 100, an insulating substrate 180 as an object to be processed is arranged between the electrodes 160A and 160B. The distance between the electrodes 160A and 160B is ordinarily about 1 mm. Further, the insulating substrate 180 is arranged at a predetermined position relative to the electrodes 160A and 160B by moving a stage (not illustrated) in a horizontal direction.

Next, a laser beam 113 from the laser beam source 110 irradiates a target position (a through hole formation position). Thus, the temperature of a laser-illuminated position 183 on the insulating substrate 180 illuminated by the laser beam 113 increases.

Within a short time after the irradiation of the laser beam 113, the switching unit 150 connects the conductors 162A and 162B with the high-frequency high-voltage power source (HF) 130 to cause high frequency and high voltage electric discharge between the electrode 160A and the electrode 160B. This electric discharge occurs just at the laser-illuminated position 183 of the laser beam 113. This is because the temperature of the laser-illuminated position 183 is locally increased by the irradiation of the laser beam 113 and the resistance of the insulating substrate at the laser-illuminated position 183 is lower than the other portion of the insulating substrate.

A great energy is applied to the laser-illuminated position on the insulating substrate 180 by the electric discharge between the electrode 160A and the electrode 160B to thereby locally melt the insulating substrate 180.

Next, the conductor 162A and the conductor 162B are connected with the DC high-voltage power source (DC) 140 by the switching unit 150, and therefore a high direct current voltage is applied between the electrode 160A and the electrode 160B. Thus, molten material at the laser-illuminated position 183 of the insulating substrate 180 is removed and a through hole 185 is formed at a desired position in the insulating substrate 180.

The laser-induced electrical discharge machine 100 illustrated in FIG. 1 is an example, and it is an obvious choice for a person ordinarily skilled in art to use a laser-induced electrical discharge machine having another structure.

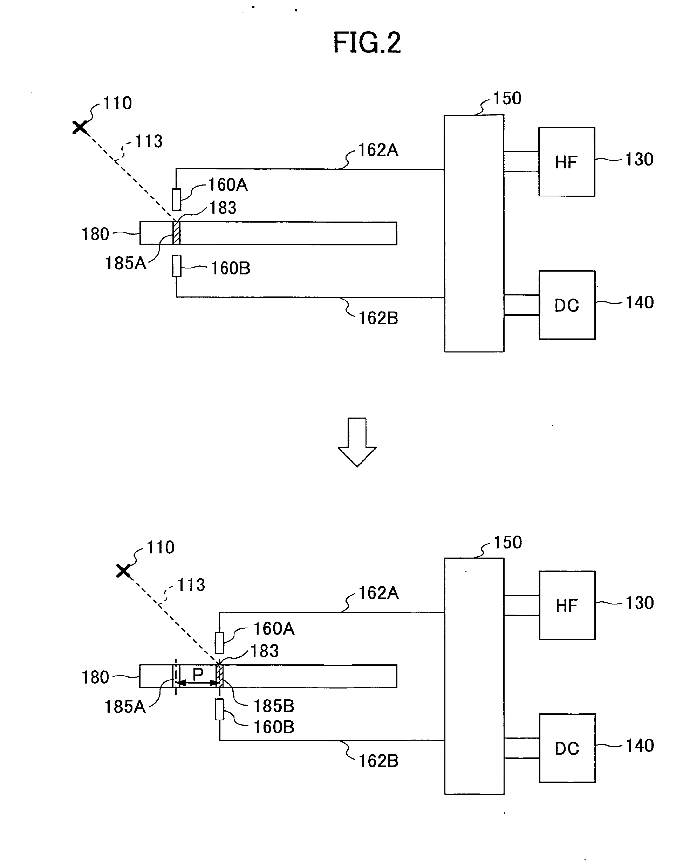

FIG. 2 schematically illustrates states of forming a plurality of through holes 185A and 185B in the insulating substrate 180 using the laser-induced electrical discharge machine 100 illustrated in FIG. 1.

Referring to FIG. 2, when a plurality of through holes are formed in the insulating substrate 180, the first through hole 185A is formed in the insulating substrate 180 at first.

Next, positions of the electrodes 160A and 160B relative to the insulating substrate 180 are moved in conformity with a pitch of forming the through holes. Then, an operation similar to an operation of forming the first through hole 185A is performed to thereby form a second through hole 185B. In an ordinary case, the pitch P between the through hole 185A and the through hole 185B is relatively narrow and is, for example, about 100 µm to 300 µm at maximum.

When the through holes 185A, 185B, ... , 185N are sequentially opened inside the insulating substrate at the pitch P, it is frequently observed that a crack occurs in the insulating substrate 180. If this crack occurs, it becomes difficult that the insulating layer having the through hole is used as, for example, an interposer.

The inventor of the present invention thinks the occurrence of the crack is by accumulation of thermal stress during opening of the through holes and has been examining a measure of reducing the problem. As a result, the present invention is finally conceived by finding that a danger of causing a crack in the insulating substrate is significantly suppressed when the order of opening the through holes is changed to a predetermined order.

According to the present invention, there is provided a method of forming the through hole in the insulating substrate using the laser-induced electrical discharge machining technique including (a) a step of preparing an insulating substrate, and (b) a step of forming n (n is an integer equal to or greater than 9) through holes in the insulating substrate in a through hole density in a range of 1000 pieces/cm² to 20000 pieces/cm² at a pitch P (µm) of 100 µm, where the pitch is in a range of 20 µm to 300 µm,
wherein the step (b) includes steps performed on the front surface of the insulating substrate:
(b1) the step of forming a first through at a first target position,
(b2) the step of forming a second through hole at a second target position, where a distance between the first target position and the second target position is greater than the pitch P (µm), ...
(bn) the step of forming an n-th through hole (the final through hole) at a n-th target position, where a distance between a (n-1)-th target position and the n-th target position is greater than the pitch P (µm).

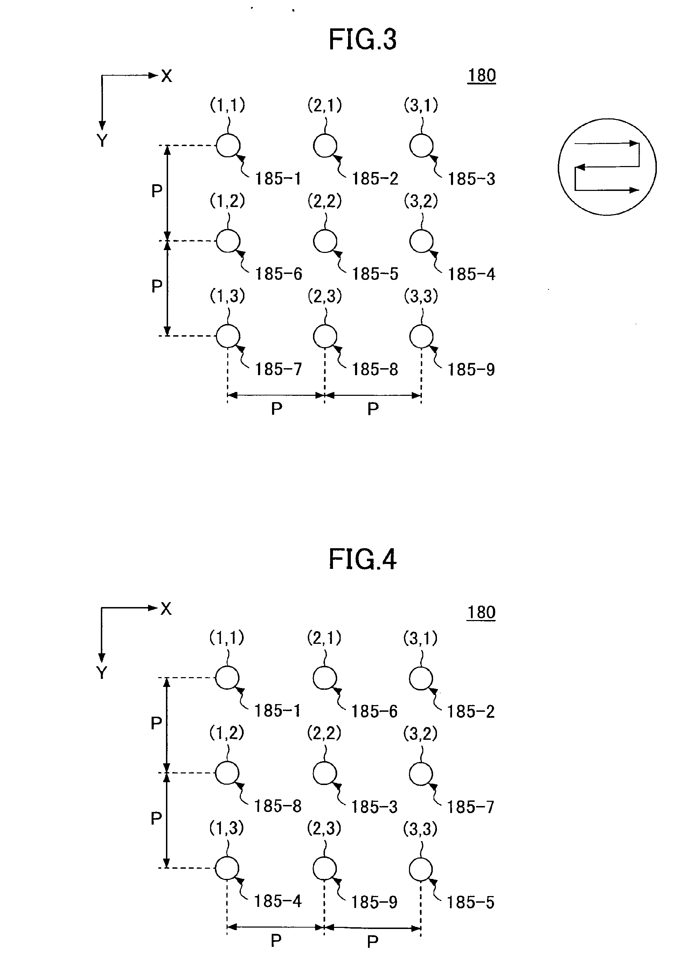

Hereinafter, referring to FIGs. 3 and 4, the effect of the present invention is described.

FIG. 3 is a plan view of a part of the insulating substrate 180, which is to be an object to be processed. Referring to FIG. 3, positions (1, 1) to (3, 3) designates positions where the through holes are formed. The positions (1, 1) to (3, 3) are arranged on a X-Y plane at a pitch P of, for example, 100 µm.

When the through hole is formed, as illustrated in FIG. 3, the position (1, 1) is a starting position, and the through holes are sequentially formed at the positions (1, 1), (2, 1), and (3, 1), the positions (3, 2), (2, 2), and (1, 2), and the positions (1, 3), (2, 3), and (3, 3) along arrows illustrated inside an upper right circle. This case of forming the through holes is described next.

In this case, as illustrated in FIG. 3, an order of forming the through holes is the first through hole (185-1) at the position (1, 1), the second through hole (185-2) at the position (2, 1) , ... , and the ninth through hole (185-9) at the position (3, 3).

As described, in a case where the through holes 185 are formed in this order, there is a danger of causing a crack by thermal stress when the currently formed through hole is formed at the position adjacent to the through hole formation position formed immediately before forming the currently formed through hole. For example, the position (2, 1) of the second through hole (185-2) is adjacent to the position (1, 1) of the first through hole (185-1), which is formed immediately before forming the second through hole (185-2). Therefore, the danger of causing the crack is high. For example, the position (3, 1) of the third through hole (185-3) is adjacent to the position (2, 1) of the second through hole (185-2), which is formed immediately before forming the third through hole (185-3). Therefore, the danger of causing the crack is high. In a manner similar thereto, the position of the n-th through hole (185-n) is adjacent to the position of the (n-1)-th through hole (185-(n-1)), which is formed immediately before forming the n-th through hole. Therefore, the danger of causing the crack is high.

According to the present application, an "adjacent" position means a through hole formation position closest to the through hole formation position of a single through hole as an object in every direction of upward, downward, rightward, and leftward directions on an X-Y plane. For example, referring to FIG. 3, the positions (2, 1), (1, 2), (3, 2), and (2, 3) are adjacent to the position (2, 2). However, the positions (1, 1), (3, 1), (1, 3), and (3, 3) are not adjacent to the position (2, 2).

FIG. 4 is a plan view of a part of the insulating substrate 180 similar to FIG. 3. Referring to FIG. 4, positions (1, 1) to (3, 3) designates positions where the through holes are formed. The positions (1, 1) to (3, 3) are arranged on an X-Y plane at a pitch P of, for example, 150 µm.

Referring to FIG. 4, the order of forming the through holes is different from that in FIG. 3. Said differently, the first through hole (185-1) is positioned at the position (1, 1), the second through hole (185-2) is positioned at the position (3, 1), the third through hole (185-3) is positioned at the position (2, 2), the fourth through hole (185-4) is positioned at the position (1, 3), the fifth through hole (185-5) is positioned at the position (3, 3), the sixth through hole (185-6) is positioned at the position (2, 1), the seventh through hole (185-7) is positioned at the position (3, 2), the eighth through hole (185-8) is positioned at the position (1, 2), and the ninth through hole (185-9) is positioned at the position (2, 3).

In this case, the position where each of the through holes is formed is not adjacent to a through hole formation position immediately before forming each of the through holes. Said differently, every position where the through holes are formed is apart by at least a distance equal to or greater than 150 µm from the through hole formation position immediately before forming each through hole. Therefore, in a case where the through holes are formed in the order illustrated in FIG. 4, a danger of causing a crack can be significantly suppressed.

Further, the order of forming the through holes illustrated in FIG. 4 is merely an example. It is obvious for a person ordinarily skilled in art that a danger of causing a crack in the insulating substrate 180 can be suppressed even in another order as long as the positions where the through holes are formed are not adjacent to the through hole formation position immediately before forming the through holes.

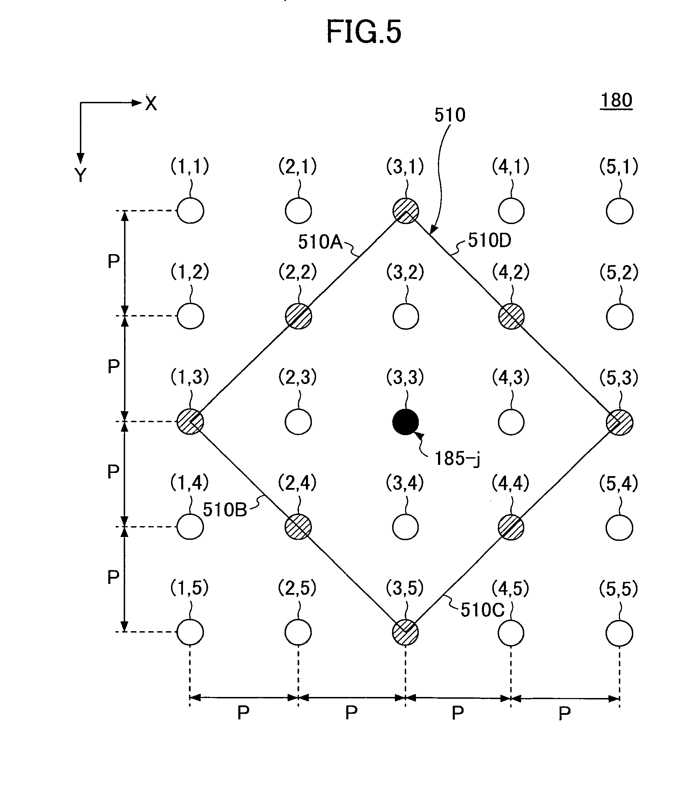

Referring to FIG. 5, another embodiment of the present invention is described.

FIG. 5 is a plan view of a part of the insulating substrate 180 similar to FIGs. 3 and 4.

Referring to FIG. 5, the number of circles O indicative of the positions where the through holes are formed is 25. In this example, the positions (1, 1) to (5, 5) where the through holes are formed are arranged in 5 rows and 5 columns on an X-Y plane. Each pitch is, for example, 80 µm.

When the through holes are formed, each target position where a next through hole is formed is selected from positions which are not adjacent to the through hole formation position immediately before forming the next through hole.

Then, a case where the j-th through hole (185-j) is formed at the position (3, 3) is described, where j is an integer between 1 to n.

In this case, as described above, the next (j+1)-th through hole formation position is selected from positions other than the positions (3, 2), (2, 3), (4, 3), and (3, 4), which are adjacent to the position (3, 3).

However, if the next (j+1)-th through hole formation position is selected from positions extremely apart from the position (3, 3) of the j-th through hole (185-j), it becomes necessary to relatively farther move the positions of the electrodes of the laser-induced electrical discharge machine relative to the insulating substrate in order to form the next (j+1)-th through hole. Therefore, an efficiency of forming the through hole is preferable with the above method of selecting the next (j+1)-th through hole formation position.

Therefore, it is preferable to select the next (j+1)-th through hole formation position using the following procedure in order to deal with this problem.

At first, there is selected 4 positions at a distance of 160 µm, which is two times of the pitch P, from the position (3, 3) where the j-th through hole (185-j) is formed. Therefore, referring to FIG. 5, the positions (3, 1), (1, 3), (3, 5), and (5, 3) are selected

Next, a square 510 having vertexes at the above four positions are drawn onto FIG. 5.

A selected group is formed by positions on the sides 510A to 510D and the vertexes of the square 510. For example, referring to FIG. 5, the selected group includes 4 positions on the sides, namely the positions (2, 2), (2, 4), (4, 4), and (4, 2), and the positions at the vertexes, namely the positions (3, 1), (1, 3), (3, 5), and (5, 3).

Next, a single (j+i)-th through hole formation position is selected from the selected groups of the positions.

Further, the through holes are formed in a procedure similar to the above after forming the through hole at the (j+1)-th through hole formation position.

In a case where the through hole formation positions are selected in accordance with the procedure, a movement of the electrodes of the laser-induced electrical discharge machine relative to the insulating substrate can be suppressed to be minimal. Therefore, it is possible to enhance efficiency of forming the through hole.

### (Method of manufacturing insulating substrate for interposer)

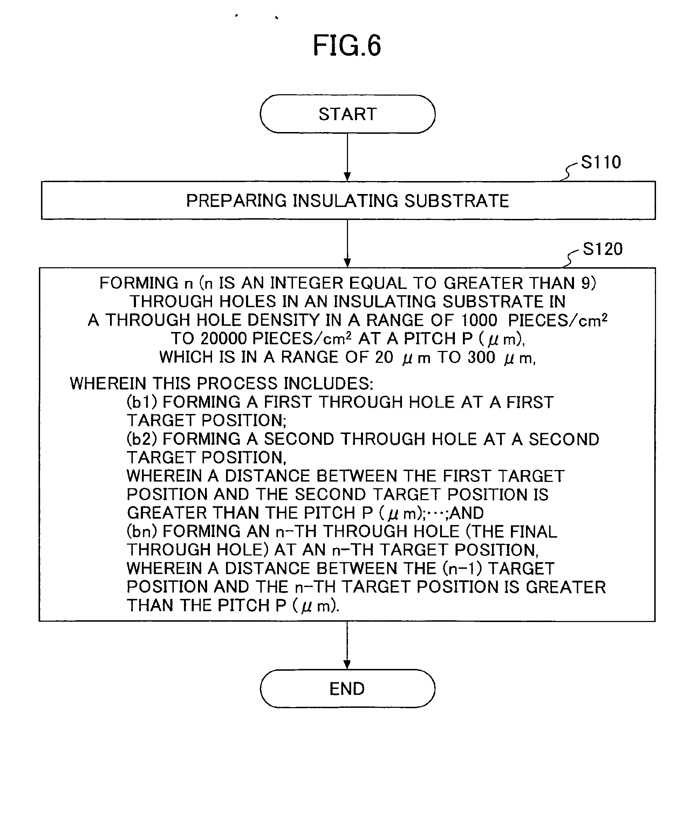

Next, referring to FIG. 6, a method of manufacturing an insulating substrate for an interposer of the present invention is described.

FIG. 6 is an exemplary flow chart schematically illustrating the method of manufacturing the insulating substrate for the interposer of the present invention.

Referring to FIG. 6, the method of manufacturing the insulating substrate for the interposer of the present invention includes:
(a) a step of preparing the insulating substrate (step S110), and
(b) forming n (n is an integer equal to or greater than 9) through holes on the insulating substrate in a through hole density in a range of 1000 pieces/cm² to 20000 pieces/cm² at a pitch P (µm) of 100 µm, where the pitch is in a range of 20 µm to 300 µm,

Hereinafter, the steps are described in detail.

### (Step S110)

At first, the insulating substrate for the interposer is prepared.

The material of the insulating substrate is not specifically limited. The insulating substrate may be a glass substrate such as soda lime glass.

The thickness of the insulating substrate is not specifically limited. The thickness of the insulating substrate is in a range of, for example, 0.03 mm to 0.5 mm. As the thickness of the insulating substrate is thinner, a time of forming the through hole is made shorter. However, handling becomes cumbersome.

### (Step S120)

Next, the laser-induced electrical discharge machining technique is used to form a plurality of through holes in the insulating substrate prepared in step S110.

The laser-induced electrical discharge machining technique to be applied is not specifically limited. For example, the plurality of through holes may be formed in the insulating substrate using the laser-induced electrical discharge machine as illustrated in, for example, FIG. 1.

The laser beam to be used may be generated by a carbon dioxide laser. Further, the output of the laser beam may be in a range of, for example, 1 W to 100 W. Further, the spot diameter of the laser beam may be in a range of, for example, 10 µm to 50 µm. However, the shape of the spot of the laser beam may be other than a circle, for example, an ellipse. The laser beam may be irradiated on the both sides of the insulating substrate.

The high-frequency high-voltage power source to be used may be a frequency in a range of 1 MHz to 100 MHz. The direct current (DC) high-voltage power source may be a power source which can apply a direct current (DC) voltage in a range of 1 kV to 250 kV. Further, a distance between the electrodes is in a range of, for example, 1 mm to 10 mm.

As described above, electrodes are arranged over and below the insulating substrate in a case where the through hole is formed in the insulating substrate. Next, under a state where a laser beam irradiates the insulating substrate and a target position (a through hole formation position) is heated, a high frequency voltage is applied to the electrodes from the high-frequency high-voltage power source to thereby cause electric discharge at the target position. With this, the insulating substrate is locally molten. Next, molten material is removed and the through hole is formed in the insulating substrate by applying the high direct voltage between the electrodes.

Every time one of the through holes is formed, the electrode is moved relative to the insulating substrate. Then, an operation similar to the above is performed at a new target position so as to continuously form the through holes in the insulating substrate. A time period after one of the through holes is formed until a next one of the through holes is formed is in a range of, for example, 1 msec to 2 msec.

The diameter of the opening portion of the through hole is in a range of, for example, 10 µm to 70 µm. The density of forming the through holes is in a range of 1000 pieces/cm² to 20000 pieces/cm². A pitch P (µm) between the through holes is in a range of, for example, 20 µm to 300 µm. The reason why the maximum value of the pitch P (µm) is 300 µm is that a thermal influence can be prevented from reaching to the through hole formed at an adjacent position. Further, the reason why the initial value of the pitch P is 20 µm is that the minimum value of an aperture diameter is about 10 µm. When the maximum value of the pitch P is 200 µm, a thermal influence may not occur depending on the thickness of the insulating layer, an aperture diameter, a discharge condition, or the like. When the maximum value of the pitch P is 150 µm, there may be a case where the thermal influence does not occur.

Within the embodiment, step S120 includes:
(b1) the step of forming the first through at the first target position,
(b2) the step of forming the second through hole at the second target position, where the distance between the first target position and the second target position is greater than the pitch P (µm), ...
(bn) the step of forming an n-th through hole at the n-th target position, where the distance between the (n-1)-th target position and the n-th target position is greater than the pitch P (µm).

Therefore, within the embodiment, the position where the through hole is formed is not adjacent to the through hole formation position immediately before forming the through hole. Therefore, it is possible to significantly suppress a danger of causing a crack in the insulating substrate.

The present invention is described above in detail with reference to specific embodiments, however, it may be apparent to those skilled in the art that various variations and modifications may be made without departing from the spirit and scope of the present invention.

This international application is based on Japanese Priority Patent Application No. 2011-231101 filed on October 20, 2011, the entire contents of Japanese Priority Patent Application No. 2011-231101 are hereby incorporated herein by reference.

### INDUSTRIAL APPLICABILITY

The present invention may be applied to manufacturing of an interposer or the like.

### DESCRIPTION OF REFERENCE NUMERALS

- 100: laser-induced electrical discharge machine
- 110: laser beam source
- 113: laser beam
- 130: high-frequency high-voltage power source
- 140: DC high-voltage power source
- 150: switching unit
- 160A, 160B: electrode
- 162A, 162B: conductor
- 180: insulating substrate
- 183: laser-illuminated position
- 185, 185A, 185B: through hole
- 510: square
- 510A-510D: side of square

## Claims

1. A method of forming a through hole in an insulating substrate using a laser-induced electrical discharge machining technique, the method comprising:
(a) preparing the insulating substrate; and
(b) forming n (n is an integer equal to or greater than 9) through holes on the insulating substrate in a through hole density in a range of 1000 pieces/cm² to 20000 pieces/cm² at a pitch P (µm) in a range of 20 µm to 300 µm,
wherein (b) includes:
(b1) forming a first through hole at a first target position on a front surface of the insulating substrate,
(b2) forming a second through hole at a second target position on the front surface of the insulating substrate, wherein a distance between the first target position and the second target position is greater than the pitch P (µm), and
(bn) forming an n-th final through hole at an n-th target position on the front surface of the insulating substrate, wherein a distance between the (n-1) target position and the n-th target position is greater than the pitch P (µm).

2. The method of forming the through hole according to claim 1,
wherein after a j-th (j is an integer between 1 to n-1) through hole is formed at a j-th target position on the surface of the insulating substrate, a (j+1)-th target position where (j+1)-th through hole is formed is selected from a plurality of target positions, which exist at 4 target positions distanced by a doubled pitch 2P from the j-th target position in upward, downward, rightward, and leftward directions and exist on sides of a square having its vertexes at the target positions distanced by the doubled pitch 2P from the j-th target position in the upward, downward, rightward, and leftward directions.

3. The method of forming the through hole according to claim 1 or 2,
wherein a time period after forming the first through hole at the first position until the second through hole is formed at the second target position is in a range of 1 msec to 2 msec.

4. The method of forming the through hole according to any one of claims 1 to 3,
wherein a diameter of the through hole is in a range of 5 µm to 100 µm.

5. The method of forming the through hole according to any one of claims 1 to 4,
wherein a thickness of the insulating substrate is in a range of 0.03 mm to 1.0 mm.

6. A method of manufacturing an insulating substrate for an interposer having a plurality of through holes using a laser-induced electrical discharge machining technique, the method comprising:
(a) preparing the insulating substrate; and
(b) forming n (n is an integer equal to or greater than 9) through holes on the insulating substrate in a through hole density in a range of 1000 pieces/cm² to 20000 pieces/cm² at a pitch P (µm) in a range of 20 µm to 300 µm,
wherein (b) includes:
(b1) forming a first through hole at a first target position on a front surface of the insulating substrate,
(b2) forming a second through hole at a second target position on the front surface of the insulating substrate, wherein a distance between the first target position and the second target position is greater than the pitch P (µm), and
(bn) forming an n-th final through hole at an n-th target position on the front surface of the insulating substrate, wherein a distance between the (n-1) target position and the n-th target position is greater than the pitch P (µm).

7. A method of forming a through hole on an insulating substrate using a laser-induced electrical discharge machining technique, the method comprising:
(a) preparing the insulating substrate; and
(b) forming n (n is an integer equal to or greater than 9) through holes on the insulating substrate in a through hole density in a range of 1000 pieces/cm² to 20000 pieces/cm² at a pitch P (µm) at predetermined target positions on a surface of the insulating substrate,
wherein the pitch P (µm) is in a range of 20 µm to 300 µm,
wherein, in (b), when the through holes corresponding to a second target position to a final target position are formed after forming one of the through holes corresponding to a first target position, the through holes each corresponding to one selected from the predetermined target positions are formed, the one being distanced longer than the pitch P and within a doubled pitch 2P from the target position selected immediately before selecting the one.
